# EUROPÄISCHE PATENTANMELDUNG

(11) **EP 2 685 581 A1**
(43) Veröffentlichungstag der Anmeldung: **15.01.2014**
(21) Anmeldenummer: 12176404.7
(22) Anmeldetag: 13.07.2012
(51) Int. Cl.: H02J 3/01, B60L 9/00

(54) **Versorgung eines Schienenfahrzeugs mit elektrischer Energie über eine abgeschirmte Energieversorgungsleitung**

(71) Anmelder: Bombardier Transportation GmbH, 10785 Berlin (DE)
(72) Erfinder: Graupner, Winfried, 12683 Berlin (DE); Hillarius, Andreas, 10709 Berlin (DE)
(74) Vertreter: Patentanwälte Bressel und Partner

(57) **Zusammenfassung**

Die Erfindung betrifft eine Anordnung zur Versorgung eines Schienenfahrzeugs (51) mit elektrischer Energie, wobei die Anordnung eine Energieversorgungsleitung (3) mit einem Anschluss zum Anschließen der Energieversorgungsleitung (3) an ein Fahrzeug-externes Stromnetz (1) aufweist und wobei die Energieversorgungsleitung (3) eine Abschirmung (55) aufweist. Die Abschirmung (55) ist über eine elektrische Verbindung (58) mit einem von dem elektrischen Potenzial der Abschirmung (55) unterschiedlichen Bezugspotenzial, insbesondere Massepotenzial (UM), verbunden. Die Anordnung weist eine Dämpfungseinrichtung (10) auf, die ausgestaltet ist, elektrische Schwingungen der Anordnung unter Beteiligung der Energieversorgungsleitung (3) zu dämpfen. Die Dämpfungseinrichtung (10) und/oder eine Prüfeinrichtung (11), die ausgestaltet ist, eine korrekte Funktion der Dämpfungseinrichtung (10) zu prüfen, ist/sind induktiv mit der elektrischen Verbindung (58) zwischen der Abschirmung (55) und dem Bezugspotenzial gekoppelt.

## Beschreibung

Die Erfindung betrifft eine Anordnung und ein Verfahren zur Versorgung eines Schienenfahrzeugs mit elektrischer Energie. Die Erfindung betrifft insbesondere das Gebiet der Schienenfahrzeuge, bei denen über eine innerhalb des Schienenfahrzeugs verlaufende elektrische Energieversorgungsleitung (zum Beispiel eine Hochspannungsleitung) mehrere (d. h. zumindest zwei) Teile des Schienenfahrzeugs verbunden sind, deren Verbraucher über die Energieversorgungsleitung versorgt werden. Insbesondere können mehrere Traktionseinheiten zur Erzeugung von Antriebsenergie des Schienenfahrzeugs über jeweils zumindest einen Stromrichter (z. B. Netz- bzw. Motor-Stromrichter) mit der Energieversorgungsleitung verbunden sein. Außer zumindest einer Traktionseinheit können insbesondere so genannte Hilfsbetriebe oder Nebenbetriebe (elektrische Verbraucher, die nicht unmittelbar der Traktion dienen) über zumindest einen Hilfsbetriebe-Stromrichter und/oder einen weiteren Stromrichter an die Energieversorgungsleitung angeschlossen sein.

Derartige verteilte Energieversorgungssysteme in Schienenfahrzeugen sind bekannt. Z. B. beschreibt EP 1 126 573 B1 eine koaxiale Hochspannungsleitung, durch die die Wagen eines Schienenfahrzeuges mit elektrischer Energie versorgt werden. Die Hochspannungsleitung wird durch Anlegen eines Stromabnehmers von einer Fahrleitung mit Strom versorgt. Bei angelegtem Stromabnehmer werden wenigstens ein Fahrzeugtransformator sowie die nachgeschalteten Traktionsumrichter und die nachgeschalteten Bordnetzumrichter mit elektrischer Energie versorgt.

Energieversorgungsleitungen, die sich zumindest durch Teile eines Schienenfahrzeugs in Fahrtrichtung hindurch erstrecken, insbesondere durch mehrere aneinander gekoppelte Wagen hindurch, sind üblicherweise geschirmt ausgeführt und besitzen zumindest einen elektrischen Leiter und eine Abschirmung. In der Regel handelt es sich um Koaxialkabel. Die Leitungs-Abschirmung kann optional in Teilabschnitten unterbrochen sein, so dass es mehrere elektrisch nicht direkt miteinander verbundene Abschirmungssegmente geben kann. Primäre Aufgabe der Abschirmung ist die Potenzialsteuerung, um Teilentladungen und somit Schäden an der Leitung zu vermeiden.

Konstruktionsbedingt bilden die zumindest eine Abschirmung und die zumindest eine elektrische Leitung eine Kapazität. Gemeinsam mit optional zusätzlich vorhandenen elektrischen Bauteilen und Einrichtungen bildet die abgeschirmte elektrische Leitung ein schwingungsfähiges System mit zumindest einer Resonanzfrequenz. Eine Anregung von Schwingungen bei der zumindest einen Resonanzfrequenz kann durch Fahrzeug-interne Einrichtungen und insbesondere auch über die Fahrzeug-externe Stromversorgung stattfinden, d. h. zum Beispiel über den Oberleitungsfahrdraht oder die Stromschiene. Diese Schwingungen im Eingangsstrom des Fahrzeugs können signaltechnische Einrichtungen (z.B. Gleiskreise zur Gleisfreimeldung) stören.

Eine übliche Maßnahme zur Dämpfung dieser Schwingungen (Störgrößen) im Eingangsstrom besteht in der Verwendung von Netzfiltern, die in den Energieversorgungskreis geschaltet werden. In Abhängigkeit von der Schaltungstopologie müssen die Bauelemente dieses Filters für die hohe Spannung und teilweise für den vollen Betriebsstrom ausgelegt werden. Hieraus resultieren ein hohes Gewicht und ein großes Bauvolumen. Darüber hinaus reduzieren diese Filter nur die vom Fahrzeug erzeugten Störgrößen im Eingangsstrom. Störgrößen, die von außen angeregt werden, können je nach Art des Netzfilters sogar verstärkt werden.

Zur Dämpfung derartiger elektrischer Schwingungen ist ferner bereits vorgeschlagen worden, z. B. in der EP 1 126 573 B1, die Abschirmung der Energieversorgungsleitung über eine Dämpfungseinrichtung mit Massepotenzial zu verbinden. Die Dämpfungseinrichtung weist insbesondere rein passive elektrische Bauteile auf, wie Kapazitäten, Induktivitäten und/oder ohmsche Widerstände (im Folgenden kurz: Widerstände). Z. B. gemäß EP 1 126 573 B1 sind zwischen Schirmpotential und dem Massepotenzial wenigstens eine Induktivität und wenigstens ein Widerstand sowie wenigstens eine Kapazität parallel geschaltet.

Da die Funktion der signaltechnischen Einrichtungen sicherheitsrelevant ist, werden hohe Anforderungen an die Zuverlässigkeit und Überprüfbarkeit der Dämpfungseinrichtung gestellt. Verändern sich die elektrischen Eigenschaften eines Bauteils der Dämpfungseinrichtung (z. B. durch Alterung oder Beschädigung) wird die Funktion der Dämpfung beeinträchtigt oder ist nicht mehr vorhanden.

Darüber hinaus kann die Wirksamkeit der Dämpfungseinrichtung durch örtlich stark schwankende Resonanzeigenschaften des Fahrleitungsnetzes (z.B. beim Wechsel des Energieversorgungsnetzes im grenzüberschreitenden Verkehr) herabgesetzt werden. Einfluss auf die korrekte Funktion der Dämpfungseinrichtung kann auch der Fahrzeugzustand haben. Bei einem Defekt von Teilsystemen der Energieversorgung (z.B. Ausfall eines Antriebssystems oder Transformators) wird der betroffene Energieversorgungszweig üblicherweise über Trenneinrichtungen spannungsfrei geschaltet, so dass das Fahrzeug den Betrieb mit reduzierter Leistung fortsetzen kann. In dieser Ausfallbetriebsart kann sich das Resonanzverhalten des gesamten Energieversorgungssystems ändern, so dass durch die Dämpfungseinrichtung gegebenenfalls keine wirksame Dämpfung mehr erreicht wird. Aus diesen beiden Gründen ist es deshalb wünschenswert, die Dämpfungseinrichtung an die sich ändernden Resonanzeigenschaften des Fahrleitungs- bzw. Energieversorgungssystems anzupassen, um jeweils eine optimale Bedämpfung zu gewährleisten.

Da die Dämpfungseinrichtung Störgrößen in einem Frequenzbereich reduzieren soll, in dem auch Gleisfreimeldeeinrichtungen betrieben werden, kann durch eine fehlerhafte Funktion der Dämpfungseinrichtung die Sicherheit des Eisenbahnbetriebs gefährdet sein. Die Gleisfreimeldeeinrichtungen arbeiten vorzugsweise im Tonfrequenzbereich von 1 kHz bis 20 kHz. Es werden jedoch auch höhere Frequenzen verwendet.

Daher besteht ein Bedarf für eine Überprüfung der korrekten Funktion der Dämpfungseinrichtung zur Gewährleistung der Betriebssicherheit. Bisher ist es üblich, die Funktion der Dämpfungseinrichtung in unregelmäßigen zeitlichen Abständen durch separate Prüfgeräte zu prüfen.

Es ist eine Aufgabe der vorliegenden Erfindung, eine Anordnung zur Versorgung eines Schienenfahrzeugs mit elektrischer Energie anzugeben, wobei die Anordnung eine elektrische Energieversorgungsleitung mit Abschirmung, bestehend aus wenigstens einem Abschirmungssegment, und eine Dämpfungseinrichtung zur Dämpfung elektrischer Schwingungen aufweist und wobei die Dämpfungseinrichtung auf einfache Weise an veränderte Schwingungsverhältnisse anpassbar sein soll, ein geringes Bauvolumen und Gewicht aufweisen soll und/oder auf einfache Weise auf korrekte Funktion überprüfbar sein soll.

Es wird vorgeschlagen, die Dämpfungseinrichtung und/oder eine Prüfeinrichtung zwischen der Abschirmung der Energieversorgungsleitung und dem Bezugspotenzial (insbesondere Massepotenzial) zu implementieren. Insbesondere werden die Dämpfungseinrichtung und/oder die Prüfeinrichtung induktiv mit einer elektrischen Verbindung zwischen der Abschirmung und dem Bezugspotenzial gekoppelt, wobei die elektrische Verbindung insbesondere eine Wicklung und somit eine Induktivität bilden kann. Die Dämpfungseinrichtung und/oder die Prüfeinrichtung sind insbesondere Bestandteile der Anordnung innerhalb des Fahrzeugs und werden daher allenfalls bei einer Reparatur der Anordnung oder dauerhaften Veränderung der Anordnung entfernt. Dies hat bezüglich der Prüfeinrichtung den Vorteil, dass eine Prüfung auf ausreichende Dämpfung von Schwingungen wiederholt und/oder automatisch durchgeführt werden kann. Es ist nicht erforderlich, dass ein Prüftechniker mit einem zum Beispiel portablen Prüfgerät in wiederkehrendem zeitlichem Abstand die Prüfung durchführt.

Die induktive Kopplung wird z. B. durch einen Trenntransformator (d. h. durch einen Transformator mit galvanischer Trennung der Primärseite und der Sekundärseite) bewirkt. Insbesondere befindet sich daher in der elektrischen Verbindung zwischen der Abschirmung und dem Bezugspotenzial die Induktivität der Primärseite eines Transformators, während die Dämpfungseinrichtung und/oder die Prüfeinrichtung über eine weitere Induktivität (insbesondere auf der Sekundärseite des Transformators) induktiv mit der Primärseite gekoppelt ist. Dabei kann die weitere Induktivität als Teil der Dämpfungseinrichtung oder als separates Teil betrachtet werden. Die Induktivitäten sind insbesondere durch Wicklungen des Transformators gebildet. Üblicherweise wird daon gesprochen, dass ein Transformator eine Hauptinduktivität sowie eine primärseitige und sekundärseitige Streuinduktivitäten besitzt. Der Begriff der Induktivität auf der Primärseite oder Sekundärseite, der auch im Weiteren verwendet wird, bezieht sich auf das jeweilige diskrete elektrische Bauteil (hier: die Wicklung des Transformators) oder auf die Gruppe von Bauteilen, das/die aufgrund seiner/ihrer Induktivität die induktive (magnetische) Kopplung ermöglicht/ermöglichen.

Sind sowohl die Dämpfungseinrichtung als auch die Prüfeinrichtung vorhanden, sind diese vorzugsweise ebenfalls galvanisch voneinander getrennt und daher z. B. über verschiedene Induktivitäten mit der Primärseite des Transformators und/oder miteinander induktiv gekoppelt. Je nach Betrachtungsweise können die verschiedenen Induktivitäten als auf der Sekundärseite und der Tertiärseite liegend bezeichnet werden, oder auf verschiedenen Sekundärseiten liegend bezeichnet werden. Die Primärwicklung des Transformators trennt die Abschirmung der Energieversorgungsleitung und das Bezugspotenzial (z.B. Fahrzeugmasse), d.h. sie ist an beide angeschlossen. Die Dämpfungseinrichtung und/oder Prüfeinrichtung ist hierbei an eine weitere Wicklung des Transformators angeschlossen. Es ist jedoch auch möglich, dass die Dämpfungseinrichtung und die Prüfeinrichtung nicht galvanisch voneinander getrennt sind und daher über zumindest eine gemeinsame Induktivität und/oder über elektrisch miteinander verbundene Induktivitäten mit der elektrischen Verbindung induktiv gekoppelt sind.

Bei der Energieversorgungsleitung handelt es sich insbesondere um eine Hochspannungsleitung. Unter einer Hochspannungsleitung wird eine elektrische Leitung verstanden, die sich auf einem im Verhältnis zu anderen Teilen der elektrischen Versorgung des Schienenfahrzeugs hohen Spannungsniveau befindet, d. h. das elektrische Potenzial der Hochspannungsleitung ist hoch im Verhältnis zu dem elektrischen Potenzial von Leitungen in den anderen Teilen der Energieversorgung des Fahrzeugs. Z.B. kann an die Hochspannungsleitung zumindest ein Teil der Energieversorgung des Fahrzeugs angeschlossen sein, der einen Transformator und/oder einen Stromrichter aufweist, so dass aus Sicht der Hochspannungsleitung jenseits des Transformators bzw. Stromrichters ein niedrigeres elektrisches Potenzial erreicht wird als das Potenzial der Hochspannungsleitung. Insbesondere kann sich das elektrische Potenzial der Hochspannungsleitung auf dem Niveau des Fahrzeug-externen Stromnetzes befinden. Das Bezugspotenzial, auf dessen Basis die elektrische Spannung der Hochspannungsleitung definiert wird, ist insbesondere das Potenzial, mit dem die Abschirmung der Hochspannungsleitung über die Primärseite des Transformators verbunden ist. In der Regel wird das Bezugspotenzial das Massepotenzial sein, welches insbesondere über die Räder des Schienenfahrzeugs mit dem elektrischen Potenzial der Schienen verbunden ist, auf denen das Schienenfahrzeug während der Fahrt rollt.

Die Dämpfungseinrichtung kann insbesondere zumindest einen ohmschen Widerstand, zumindest eine Induktivität (die nicht zur induktiven Kopplung an die elektrische Verbindung zwischen Abschirmung und Bezugspotenzial dient) und/oder zumindest einer Kapazität aufweisen. Wenn die Dämpfungseinrichtung induktiv mit der elektrischen Verbindung gekoppelt ist, ist es auch nicht ausgeschlossen, dass die elektrische Verbindung zwischen der Abschirmung und dem Bezugspotenzial zusätzlich zu der Induktivität, über der sie mit der Dämpfungseinrichtung gekoppelt ist, außerdem zumindest ein passives elektrisches Bauteil aufweist, dass der Dämpfung von Schwingungen dient.

Wenn die Dämpfungseinrichtung lediglich induktiv (und daher galvanisch getrennt) mit der elektrischen Verbindung zwischen der Abschirmung und dem Bezugspotenzial gekoppelt ist, ist die Dämpfungseinrichtung nicht Teil der elektrischen Verbindung zwischen der Abschirmung und dem Bezugspotenzial in dem für den Personenschutz und Gerätschutz kritischen Hochspannungsbereich. Der Aufwand für eine Anpassung oder Änderung der Eigenschaften der Dämpfungseinrichtung, z. B. durch Auswechseln der Dämpfungseinrichtung gegen eine andere oder durch Auswechseln von Teilen der Dämpfungseinrichtung, ist daher verringert. Ferner sind gegenüber dem Einsatz von Netzfiltern, die stromnetzseitig (insbesondere außerhalb des Schienenfahrzeugs) elektrische Schwingungen dämpfen, Bauvolumen und Gewicht reduziert.

Im Fall der Prüfeinrichtung, die dauerhaft als Teil des Schienenfahrzeugs induktiv und insbesondere galvanisch getrennt mit der elektrischen Verbindung zwischen der Abschirmung und dem Bezugspotenzial gekoppelt ist, wird eine Prüfmöglichkeit geschaffen, die es in einfacher Weise erlaubt, immer wieder während des Betriebes eines Schienenfahrzeuges zu prüfen, ob die Dämpfungseinrichtung korrekt funktioniert und/oder ob andere Teile der Anordnung bezüglich der Schwingungsdämpfung korrekt funktionieren.

Insbesondere wird vorgeschlagen: eine Anordnung zur Versorgung eines Schienenfahrzeugs mit elektrischer Energie, wobei:
- die Anordnung eine Energieversorgungsleitung mit einem Anschluss zum Anschließen der Energieversorgungsleitung an ein Fahrzeug-externes Stromnetz aufweist, wobei die Energieversorgungsleitung eine Abschirmung zur Abschirmung elektromagnetischer Felder aufweist,
- die Abschirmung über eine elektrische Verbindung mit einem von dem elektrischen Potenzial der Abschirmung unterschiedlichen Bezugspotenzial, insbesondere Massepotenzial, verbunden ist,
- die Anordnung eine Dämpfungseinrichtung aufweist, die ausgestaltet ist, elektrische Schwingungen der Anordnung unter Beteiligung der Energieversorgungsleitung zu dämpfen,
- die Dämpfungseinrichtung induktiv mit der elektrischen Verbindung zwischen der Abschirmung und dem Bezugspotenzial gekoppelt ist.

Ferner wird ein Verfahren vorgeschlagen zur Versorgung eines Schienenfahrzeugs mit elektrischer Energie, wobei das Schienenfahrzeug über eine Energieversorgungsleitung, die mit einem Fahrzeug-externes Stromnetz verbunden ist, mit elektrischer Energie versorgt wird. Die Energieversorgungsleitung wird mit einer Abschirmung betrieben. Dadurch werden elektromagnetische Felder abgeschirmt und/oder wird eine Potentialsteuerung durchgeführt. Die Abschirmung ist während der Versorgung des Schienenfahrzeugs mit elektrischer Energie, die über die Energieversorgungsleitung stattfindet, über eine elektrische Verbindung mit einem von dem elektrischen Potenzial der Abschirmung unterschiedlichen Bezugspotenzial, insbesondere Massepotenzial, verbunden. Elektrische Schwingungen der Anordnung, die unter Beteiligung der Hochspannungsleitung auftreten, werden gedämpft. Die Dämpfungseinrichtung wird induktiv gekoppelt mit der elektrischen Verbindung zwischen der Abschirmung und dem Bezugspotenzial betrieben.

Alternativ oder zusätzlich wird vorgeschlagen: eine Anordnung zur Versorgung eines Schienenfahrzeugs mit elektrischer Energie, wobei:
- die Anordnung eine Energieversorgungsleitung mit einem Anschluss zum Anschließen der Energieversorgungsleitung an ein Fahrzeug-externes Stromnetz aufweist, wobei die Energieversorgungsleitung eine Abschirmung zur Abschirmung elektromagnetischer Felder aufweist,
- die Abschirmung über eine elektrische Verbindung mit einem von dem elektrischen Potenzial der Abschirmung unterschiedlichen Bezugspotenzial, insbesondere Massepotenzial, verbunden ist,
- die Anordnung eine Dämpfungseinrichtung aufweist, die ausgestaltet ist, elektrische Schwingungen der Anordnung unter Beteiligung der Energieversorgungsleitung zu dämpfen,
wobei eine Prüfeinrichtung, die ausgestaltet ist, eine korrekte Funktion der Dämpfungseinrichtung zu prüfen, induktiv mit der elektrischen Verbindung zwischen der Abschirmung und dem Bezugspotenzial gekoppelt ist..

Ferner wird ein Verfahren vorgeschlagen zur Versorgung eines Schienenfahrzeugs mit elektrischer Energie, wobei das Schienenfahrzeug über eine Energieversorgungsleitung, die mit einem Fahrzeug-externes Stromnetz verbunden ist, mit elektrischer Energie versorgt wird. Mittels einer Abschirmung der Energieversorgungsleitung werden elektromagnetische Felder abgeschirmt. Die Abschirmung ist während der Versorgung des Schienenfahrzeugs mit elektrischer Energie, die über die Energieversorgungsleitung stattfindet, über eine elektrische Verbindung mit einem von dem elektrischen Potenzial der Abschirmung unterschiedlichen Bezugspotenzial, insbesondere Massepotenzial, verbunden. Elektrische Schwingungen der Anordnung, die unter Beteiligung der Energieversorgungsleitung auftreten, werden gedämpft. Eine Prüfeinrichtung, die induktiv mit der elektrischen Verbindung zwischen der Abschirmung und dem Bezugspotenzial gekoppelt ist, prüft eine ausreichende Dämpfung der elektrischen Schwingungen.

Insbesondere weist die Prüfeinrichtung zumindest eine Messeinrichtung auf, die ausgestaltet ist, eine (insbesondere elektrische) Messgröße zu messen, die ein Maß für die korrekte Funktion der Dämpfungseinrichtung ist. Z. B. weist die Prüfeinrichtung eine Spannungs-Messeinrichtung auf, die während des Prüfeinganges eine elektrische Spannung misst. Vorzugsweise ist die gemessene Spannung die über die Induktivität, abfallende Spannung, insbesondere über die Sekundärseite eines Transformators, über die die Prüfeinrichtung an die elektrische Verbindung induktiv angekoppelt ist. Sie kann jedoch auch eine daraus abgeleitete Spannung sein, z. B. eine über einen Spannungsteiler erzeugte, reduzierte Spannung. Bei einer Weiterbildung des erfindungsgemäßen Verfahrens findet dementsprechend die Messung der Messgröße statt.

Z.B. kann die Amplitude der gemessenen Spannung als Maß für die korrekte Funktion der Dämpfungseinrichtung herangezogen werden. Vorzugsweise wird dabei die Amplitude frequenzbezogen ausgewertet, d.h. abhängig von der Frequenz der gemessenen Spannung.

Vorzugsweise wird die von der Messeinrichtung gemessene Messgröße (die insbesondere zeitabhängig und/oder frequenzabhängig sein kann) mit einer entsprechenden Vergleichsgröße und/oder zumindest einem Grenzwert (insbesondere mit dem unteren und dem oberen Grenzwert eines Toleranzwertebereichs) verglichen (insbesondere durch eine entsprechende Vergleichseinrichtung der Prüfeinrichtung). Die Vergleichsgröße entspricht einem Sollbetriebszustand der Dämpfungseinrichtung, in dem die Dämpfungseinrichtung korrekt funktioniert, d.h. eine ausreichende Dämpfung von Schwingungen bewirkt. Wenn hier von einer korrekten Funktion der Dämpfungseinrichtung die Rede ist, schließt dies das schwingungsfähige System ein, dessen Teil die Dämpfungseinrichtung ist. Ist daher z.B. die Energieversorgungsleitung defekt und hat sich daher z.B. die Resonanzfrequenz verändert und bewirkt die Dämpfungseinrichtung bei der veränderten Resonanzfrequenz keine ausreichende Dämpfung, ist möglicherweise keine korrekte Funktion der Dämpfungseinrichtung vorhanden, obwohl die Bauteile der Dämpfungseinrichtung möglicherweise unveränderte Eigenschaften haben. Alternativ zu einer korrekten Funktion der Dämpfungseinrichtung kann daher von einer ausreichenden Dämpfung gesprochen werden. Wenn von "der Dämpfungseinrichtung" die Rede ist, schließt dies ausdrücklich auch den Fall mit ein, dass mehr als eine Dämpfungseinrichtung Teil der gesamten Anordnung ist.

Diese ausreichende Dämpfung kann z.B. für einzelne Frequenzen und/oder für zumindest einen Frequenzbereich gefordert und/oder überprüft werden. Es kann auch die ausreichende Dämpfung für lediglich eine einzige Frequenz gefordert und/oder überprüft werden. Im Fall von mehreren Frequenzen kann die Dämpfung z. B. anhand von unterschiedlichen, jeweils für die einzelnen Frequenzen oder für den Frequenzbereich definierten Dämpfungsfaktoren und/oder Schwingungsamplituden überprüft werden.

Z.B. ist zumindest ein Grenzwert (insbesondere ein Toleranzwertebereich) vorgegeben für ein Ergebnis eines Vergleichs der von der Messeinrichtung gemessenen Messgröße mit der Vergleichsgröße und wird entschieden, dass keine ausreichende Dämpfung bewirkt wird, wenn der Grenzwert oder einer der Grenzwerte (in der jeweiligen Richtung entweder ansteigend oder abfallend) überschritten wird. Die Art des Grenzwertes hängt von der Art des Vergleichs zwischen Messgröße und Vergleichsgröße ab. Bei einer einzigen Frequenz, bei der die ausreichende Dämpfung vorhanden sein soll, ist der Grenzwert z.B. ein Wert des Dämpfungsfaktors (bzw. ist der Toleranzwertebereich durch Werte des Dämpfungsfaktors begrenzt), der durch Bildung eines entsprechenden Verhältnisses zwischen der Messgröße und der Vergleichsgröße gebildet wird. Messgröße und Vergleichsgröße können in diesem Fall z.B. die Spannungsamplituden der gemessenen Spannung der Anordnung oder der Dämpfungseinrichtung einerseits und eines Testsignals andererseits sein, mit dem das schwingungsfähige System zu Schwingungen angeregt wird.

Eine andere Möglichkeit besteht darin, die Vergleichsgröße durch Modellberechnung oder durch Messung für den Fall einer ausreichenden Dämpfung der Dämpfungseinrichtung zu ermitteln. Für einen realen Betriebszustand der Anordnung, der auf ausreichende Dämpfung zu prüfen ist, kann dann die Messgröße gemessen werden und mit der Vergleichsgröße verglichen werden. Da die Vergleichsgröße den Sollzustand ausreichender Dämpfung repräsentiert, kann durch den Vergleich ermittelt werden, ob eine ausreichende Dämpfung vorliegt. Für die Auswertung des Vergleichs gibt es wieder mehrere Möglichkeiten, zum Beispiel Frequenz-selektive Auswertung, Auswertung für lediglich eine Frequenz, Auswertung für zumindest einen Frequenzbereich und Kombinationen davon. Wiederum kann zumindest ein Grenzwert bzw. ein Toleranzwertebereich vorgegeben werden, der/das in diesem Fall den maximal zulässigen Unterschied zwischen Vergleichsgröße und Messgröße definiert. Ist der Grenzwert überschritten, liegt keine ausreichende Dämpfung vor. Allgemeiner formuliert ist es insbesondere möglich, die Funktion der Dämpfungseinrichtung unter Verwendung einer Vergleichsgröße, zumindest eines Grenzwertes und/oder auf andere Weise zu beurteilen. Z.B. kann ein gemeinsamer Grenzwert oder ein gemeinsamer Toleranzwertebereich für die Dämpfung bei verschiedenen Frequenzen definiert und dessen Einhaltung überprüft werden.

Alternativ jedoch kann auf den Vergleich mit einer Vergleichsgröße verzichtet werden und die Messgröße zum Beispiel unmittelbar mit einem Grenzwert verglichen werden. Insbesondere kann die Messgröße die Spannungsamplitude des schwingungsfähigen Systems an der Spannungs-Messeinrichtung sein. In diesem Fall kann die Vergleichsgröße z.B. bei einer bestimmten, vorgegebenen Frequenz einen vorgegebenen Spannungsgrenzwert haben. Überschreitet die gemessene Spannung diesen Spannungsgrenzwert zum Beispiel bei einer vorgegebenen Frequenz, ist die Dämpfung bei dieser Frequenz nicht ausreichend.

Insbesondere ist es auch möglich, mehr als eine Messgröße durch die Messeinrichtung zu messen, z.B. die oben erwähnte elektrische Spannung und zusätzlich einen elektrischen Strom, zum Beispiel einen Strom durch eine Anschlussverbindung der Prüfeinrichtung zu einem Teil der Anordnung, insbesondere einen Strom von einer Signalquelle der Prüfeinrichtung zur Sekundärwicklung des Transformators, über den die Prüfeinrichtung an die Verbindung zwischen Schirmpotenzial und Massepotential angeschlossen ist. Durch Quotientenbildung von Spannung und Strom kann z.B. der Wechselstromwiderstand der Dämpfungseinrichtung oder eines anderen Teils des schwingungsfähigen Systems gebildet werden, d.h. die Impedanz berechnet werden.

Vorzugsweise weist die Prüfeinrichtung eine Signalquelle auf, die ausgestaltet ist, ein Signal zu erzeugen, mit dem die Anordnung oder ein Teil der Anordnung zu elektrischen Schwingungen angeregt wird. Die Signalquelle kann auch als Signalerzeugungseinrichtung bezeichnet werden und das Signal als Testsignal. Möglichkeiten für ein Testsignal sind z.B. ein sinusförmiges (also lediglich eine Frequenz aufweisendes) Testsignal oder ein Testsignal mit mehreren Frequenzen, z.B. ein Impulssignal. Das Testsignal kann durch den zeitlichen Verlauf der elektrische Spannung und/oder des elektrischen Stroms definiert sein/werden. Insbesondere kann das Testsignal von der Signalquelle über dieselben elektrischen Anschlüsse und/oder Verbindungen in die Anordnung oder den Teil der Anordnung eingekoppelt werden, über die auch die Messeinrichtung an die Anordnung oder den Teil der Anordnung angeschlossen ist.

Es ist jedoch auch möglich, Signalquelle und Messeinrichtung über verschiedene Anschlüsse und/oder elektrische Verbindungen an die Anordnung anzuschließen. Bevorzugt wird nur, dass mehr als eine Signalquelle vorhanden ist, so dass Testsignale in verschiedene Teile der Anordnung eingekoppelt werden können. Ist, wie weiterhin bevorzugt, mit jeder der Signalquellen eine Messeinrichtung kombiniert, können die einzelnen Messeinrichtungen die Reaktion der Anordnung auf die einzelnen Testsignale und auch auf gleichzeitig erzeugte und in die Anordnung eingekoppelte Testsignale messen.

Wird die korrekte Funktion der Dämpfungseinrichtung mittels zumindest eines Testsignals aus einer Signalquelle geprüft, ist das zumindest eine Testsignal vorzugsweise vorgegeben und ist ferner ein Kriterium vorgegeben, bei dessen Erfüllung auf korrekte Funktion der Dämpfungseinrichtung erkannt wird. Alternativ kann bei Erfüllung des Kriteriums auf inkorrekte Funktion, d.h. nicht ausreichende Dämpfung der Dämpfungseinrichtung, erkannt werden. Bei dem Kriterium kann es sich insbesondere um das Kriterium handeln, dass der o.g. Grenzwert überschritten wird (z.B. eine maximale Spannungsamplitude nach oben oder z.B. ein minimaler Dämpfungsfaktor nach unten). Vorzugsweise weist die Energieversorgungsanordnung mehr als eine elektrische Schnittstelle zwischen der Abschirmung der Energieversorgungsleitung und dem Bezugspotential oder verschiedenen Bezugspotentialen auf. Unter einer Schnittstelle wird eine elektrische Verbindung zwischen der Abschirmung der Energieversorgungsleitung und dem Bezugspotential verstanden, die eine induktive Ankopplung ermöglicht.

In jedem Fall wird es bei einer Mehrzahl der elektrischen Schnittstellen zwischen Schirmpotenzialen und Bezugspotential bevorzugt, dass an jeder der elektrischen Schnittstellen eine Induktivität eingefügt ist, an die eine Prüfeinrichtung induktiv angekoppelt ist. Ferner wird bevorzugt, dass jede der Prüfeinrichtungen eine Messeinrichtung aufweist und eine Signaleinrichtung zum Einkoppeln eines Testsignals aufweist. Wird mehr als eine Dämpfungseinrichtung verwendet, ist es günstig, wenn Abschirmungssegmente, an die jeweils eine Dämpfungseinrichtung angeschlossen ist, nicht direkt miteinander verbunden sind.

Alternativ oder zusätzlich ist an jeder der zumindest zwei elektrischen Schnittstellen zwischen den Schirmpotentialen und dem Bezugspotential oder mehreren Bezugspotentialen eine Induktivität induktiv mit einer Dämpfungseinrichtung auf der Sekundärseite gekoppelt. Durch die Verwendung mehrerer Dämpfungs- und Prüfeinrichtungen, die an verschiedenen Stellen im Energieversorgungssystem des Fahrzeugs angeordnet sind, kann die Zuverlässigkeit erhöht werden, da z.B. bei einer nicht korrekten Funktion einer Dämpfungseinrichtung noch eine ausreichende Dämpfung im Energieversorgungssystem des Fahrzeugs durch die anderen Dämpfungseinrichtungen gewährleistet werden kann. Die Verwendung mehrerer Dämpfungseinrichtungen ist auch von Vorteil, wenn ein Schienenfahrzeug in Form eines Zugverbandes einzelne Wagen besitzt, die über eine gemeinsame abgeschirmte Energieversorgungsleitung verbunden sind. In diesem Fall kann jeder Wagen über mindestens eine Dämpfungseinrichtung verfügen.

Ist mit zumindest zwei elektrischen Schnittstellen zwischen den Abschirmungen der Energieversorgungsleitung und einem oder mehreren Bezugspotentialen jeweils eine Dämpfungseinrichtung und eine Prüfeinrichtung induktiv gekoppelt, kann die Prüfeinrichtung besonders gut die Dämpfungsfunktion der Dämpfungseinrichtung prüfen, die mit derselben Schnittstelle gekoppelt ist, und kann außerdem Fernwirkungen der Dämpfungseinrichtung prüfen, die auf die Funktion der Dämpfungseinrichtung zurückzuführen sind, welche mit einer anderen Schnittstelle, und eventuell mit einem anderen Abschirmungssegment, als die prüfende Prüfeinrichtung induktiv gekoppelt ist. Auch die andere Prüfeinrichtung kann in gleicher Weise die Dämpfungswirkung der lokalen Dämpfungseinrichtung und die Fernwirkungen prüfen. Dabei wird es bevorzugt, dass nacheinander Testsignale an verschiedenen Stellen der Anordnung erzeugt und in die Anordnung eingekoppelt werden, z.B. an den Orten der Prüfeinrichtungen. Wird ein Testsignal induktiv in einen elektrischen Pfad zwischen der Abschirmung und einem Bezugspotential eingekoppelt, kann eine Prüfeinrichtung, die galvanisch getrennt an eine andere elektrische Schnittstelle zwischen der Abschirmung und einem Bezugspotential gekoppelt ist, nicht nur die Fernwirkung der entfernt angeordneten Dämpfungseinrichtung feststellen (soweit diese entfernte Dämpfungsvorrichtung vorhanden ist), sondern auch z.B. Fehler der Energieversorgungsleitung, wie z.B. fehlerhafte elektrische Isolierung zwischen Abschirmung und einer Leitungsader, die auf hohem elektrischen Potential betrieben wird.

Wenn Testsignale an verschiedenen Anschlüssen in die Energieversorgungsanordnung eingekoppelt werden bzw. einkoppelbar sind, wird es bevorzugt, dass die Prüfeinrichtung oder jede der Prüfeinrichtungen über verschiedene Vergleichsgrößen und/oder Grenzwerte und/oder Kriterien für die Feststellung der korrekten Dämpfungsfunktion oder nicht korrekten Dämpfungsfunktion verfügen, wobei die verschiedenen Werte/Größen/Kriterien jeweils einem der Testsignale zugeordnet sind. Die jeweilige Prüfeinrichtung wertet jedes Testsignal einzeln (sofern überhaupt eine Auswertung dieses Testsignals, d.h. der Reaktion des schwingungsfähigen Systems auf das Testsignal stattfindet) unter Verwendung lediglich der zugeordneten Vergleichsgröße und/oder des zugeordneten Grenzwertes und/oder des zugeordneten Kriteriums aus.

Bei der elektrischen Energieversorgungsanordnung, die die Energieversorgungsleitung aufweist, kann es sich um eine Anordnung handeln, die an einem Wechselspannungsnetz betrieben wird, oder die an einem Gleichspannungsnetz betrieben wird oder die wahlweise an einem Wechselspannungsnetz oder einem Gleichspannungsnetz betrieben wird. Daher kann die Energieversorgungsleitung je nach Betriebsart eine Wechselspannungsleitung oder eine Gleichspannungsleitung sein.

Ausführungsbeispiele der Erfindung werden nun unter Bezugnahme auf die beigefügten Zeichnungen beschrieben. Die einzelnen Figuren der Zeichnung zeigen:
- Fig. 1: schematisch ein Schienenfahrzeug mit zwei Fahrzeugteilen, wobei elektrische Einrichtungen in beiden Fahrzeugteilen über eine gemeinsame Energieversorgungsleitung mit elektrischer Energie aus einem Fahrzeug-externen Versorgungsnetz versorgt werden,
- Fig. 2: eine Schaltungsanordnung einer Prüfeinrichtung zur Prüfung, ob elektrische Schwingungen in der Energieversorgungsanordnung ausreichend gedämpft werden, wobei die Prüfeinrichtung eine Spannungsmesseinrichtung und eine Strommesseinrichtung aufweist,
- Fig. 3: eine Prüfeinrichtung wie in Fig. 2, wobei die Prüfeinrichtung jedoch keine Strommesseinrichtung aufweist, und
- Fig. 4: eine Schaltungsanordnung, die ein Ausführungsbeispiel einer Dämpfungseinrichtung ist.

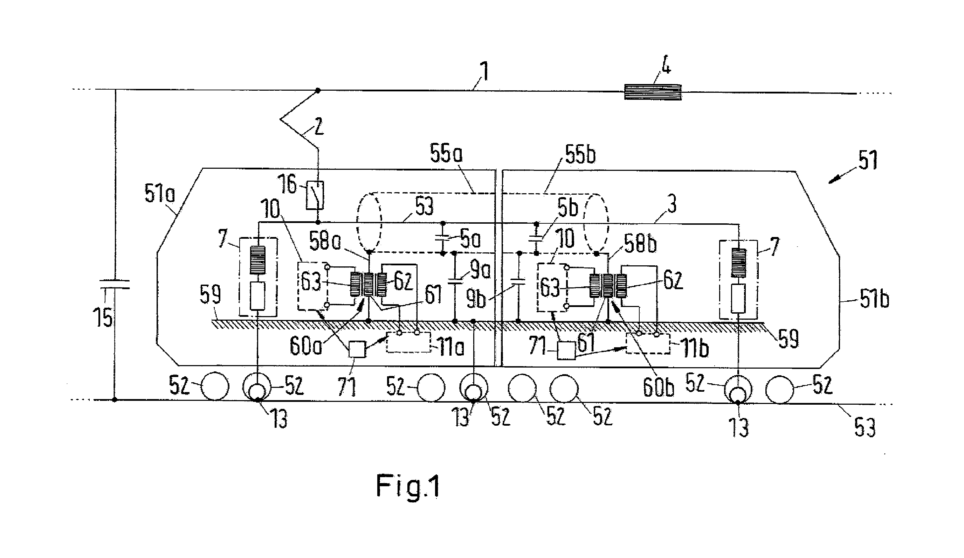

Das in Fig. 1 dargestellte Schienenfahrzeug 51 weist einen ersten Fahrzeugteil 51 a und einen zweiten, mit dem ersten Fahrzeugteil 51 a gekoppelten Fahrzeugteil 51 b auf. In der Praxis können alternativ mehr als zwei Fahrzeugteile in Fahrtrichtung (von rechts nach links oder von links nach rechts in Fig. 1 verlaufend) hintereinander angeordnet sein und miteinander gekoppelt sein. Das Fahrzeug 51 rollt mit seinen schematisch angedeuteten Rädern 52 auf einer Fahrschiene 53. Oberhalb des Fahrzeugs 51 ist eine elektrische Leitung 1, z. B. der Fahrdraht eines Oberleitung, dargestellt. In der Art eines Ersatzschaltbildes weist die elektrische Leitung 1 eine Leitungsinduktivität 4 auf. Ferner ist in dem dargestellten Ersatzschaltbild auch eine zwischen der elektrischen Leitung 1 und der Fahrschiene 53 bestehende parasitäre Kapazität 15 dargestellt.

Durch die elektrische Leitung 1 und einen Stromabnehmer 2 des Fahrzeugs 51, der über einen Hauptschalter 16 an eine Energieversorgungsleitung 3 des Fahrzeugs 51 ankoppelbar ist, wird das Fahrzeug 51 mit elektrischer Energie insbesondere für Antriebe und Hilfsbetriebe versorgt. In dem Ausführungsbeispiel handelt es sich z. B. um eine Versorgung mit Wechselstrom.

Die Energieversorgungsleitung 3, die sich durch die Fahrzeugteile 51 a, 51 b erstreckt, ist zumindest abschnittsweise in der Art einer Koaxialleitung abgeschirmt. Zwischen den Abschirmungssegmenten 55a und 55b, die sich über verschiedene Längsabschnitte der Energieversorgungsleitung 3 erstrecken und sich in den verschiedenen Fahrzeugteilen 51 a, 51 b befinden, und dem Innenleiter 53 der Energieversorgungsleitung 3 bestehen ebenfalls jeweils parasitäre Kapazitäten 5a, 5b. Da die Abschirmungssegmente 55a und 55b nicht unmittelbar elektrisch miteinander verbunden sind, bilden sich im allgemeinen unterschiedliche Schirmpotenziale aus, das heißt die Spannung zwischen den einzelnen Abschirmungssegmenten und dem Bezugspotenzial ist im allgemeinen unterschiedlich. Ferner ist in jedem Fahrzeugteil 51 a, 51 b ein Haupttransformator 7 der elektrischen Energieversorgungsanordnung vorhanden, der in dem Ersatzschaltbild durch jeweils eine Induktivität und einen ohmschen Widerstand, die zueinander in Reihe geschaltet sind, dargestellt ist. Über die Haupttransformatoren 7 besteht eine Verbindung vom Innenleiter 53 der Energieversorgungsleitung 3 zu den Radsatzkontakten 13 des Schienenfahrzeugs 51. Die Radsatzkontakte 13 stellen über die Radsätze 52 die Verbindung zur Fahrschiene 53 her. Nicht näher dargestellt sind die Sekundärseiten der Haupttransformatoren 7 und die damit verbundenen Systeme und Einrichtungen des Schienenfahrzeugs, welche mit elektrischer Energie aus der elektrischen Leitung 1 zu versorgen sind.

Die Abschirmungen 55a und 55b sind in jedem Fahrzeugteil 51 a, 51 b über eine elektrische Leitung 58a, 58b und die Primärwicklung 61 des Trenntransformators 60a , 60b mit Massepotential 59 verbunden, z. B. mit dem Wagenkasten des Schienenfahrzeugs 51 aus elektrisch leitendem Material. Fig. 1 zeigt, dass zwischen den Abschirmungen 55a und 55b und dem Massepotenzial 59 ebenfalls parasitäre Kapazitäten 9a und 9b existieren, die verschiedene Werte haben können.

In den elektrischen Strompfaden 58a, 58b ist jeweils die Primärwicklung 61 eines Trenntransformators 60a, 60b angeordnet. Diese Trenntransformatoren 60a, 60b weisen in dem Ausführungsbeispiel jeweils eine Sekundärwicklung 62 und eine Tertiärwicklung 63 auf. Die drei Wicklungen 61, 62, 63 des Transformators 60 sind galvanisch voneinander getrennt, d. h. es besteht kein niederohmiger elektrischer Kontakt zwischen ihnen. Alternativ können die Sekundärwicklung 62 und die Tertiärwicklung 63 auch galvanisch miteinander verbunden sein. Über die Sekundärwicklung 62 ist jeweils eine Prüfeinrichtung 11a, 11 b an die Primärwicklung 61 angekoppelt. Über die Tertiärwicklung 63 ist eine Dämpfungseinrichtung 10 zur Bedämpfung von elektromagnetischen Schwingungen an die Primärwicklung 61 angekoppelt. Dies gilt jeweils für beide Fahrzeugteile 51 a, 51 b. Alternativ kann die Dämpfungs- und Prüfeinrichtung auch nur in einem Fahrzeugteil installiert sein.

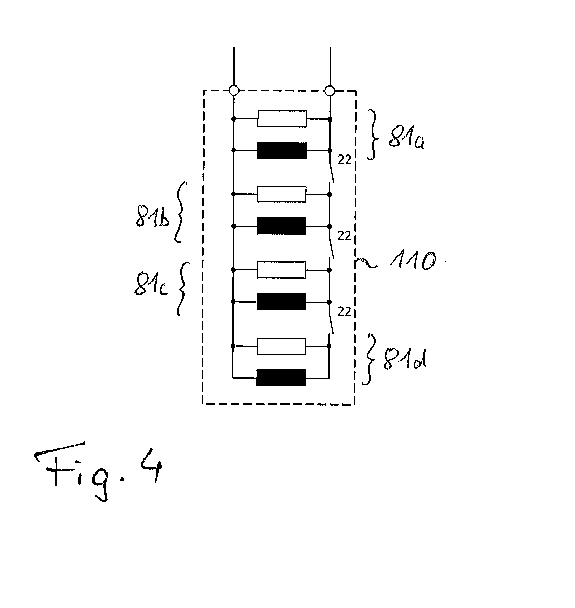

Bei der Dämpfungseinrichtung 10, die sich in jedem der Fahrzeugteile 51 a, 51 b befindet, handelt es sich insbesondere um die Dämpfungseinrichtung, die noch anhand von Fig. 4 erläutert wird. Zumindest enthält die Dämpfungseinrichtung 10 vorzugsweise einen ohmschen Widerstand, der über die in Fig. 1 durch kleine Kreise dargestellten Anschlüsse an die Tertiärwicklung 63 angeschlossen ist.

Insbesondere führen die parasitären Kapazitäten 5, 9, 15 und die Induktivitäten 4 der Leitung und/oder weiterer Teile der Energieversorgungsanordnung bei entsprechender Anregung zu elektrischen Schwingungen. Z. B. kann die Übertragungsfunktion der Dämpfungseinrichtung 10 so konzipiert werden, dass in dem betreffenden Frequenzbereich ein Bandsperrverhalten erzielt wird. Der Frequenzbereich ist z. B. ein vorgegebener Frequenzbereich, in dem Schwingungen mit bestimmten Amplituden verhindert werden müssen. Bei der Berechnung der Übertragungsfunktion sind die parallel zu den Trenntransformatoren 60a, 60b liegenden parasitären Kapazitäten 9 zu berücksichtigen.

Insbesondere können sich die elektrischen Eigenschaften der Dämpfungseinrichtung 10 ändern, z. B. wenn ein Bauteil defekt wird. Aber auch im Laufe der Zeit kann durch eine Alterung der Bauteile oder des Bauteils eine Veränderung der elektrischen Eigenschaften stattfinden. Diese Veränderung führt zu einem anderen Dämpfungsverhalten, das möglicherweise nicht mehr für einen sicheren oder vorgegebenen Betrieb des Schienenfahrzeugs ausreicht.

Insbesondere aus diesem Grund ist in dem Ausführungsbeispiel der Fig. 1 über jede der Sekundärwicklungen 62 eine Prüfeinrichtung 11 an die Primärwicklung 61 angekoppelt.

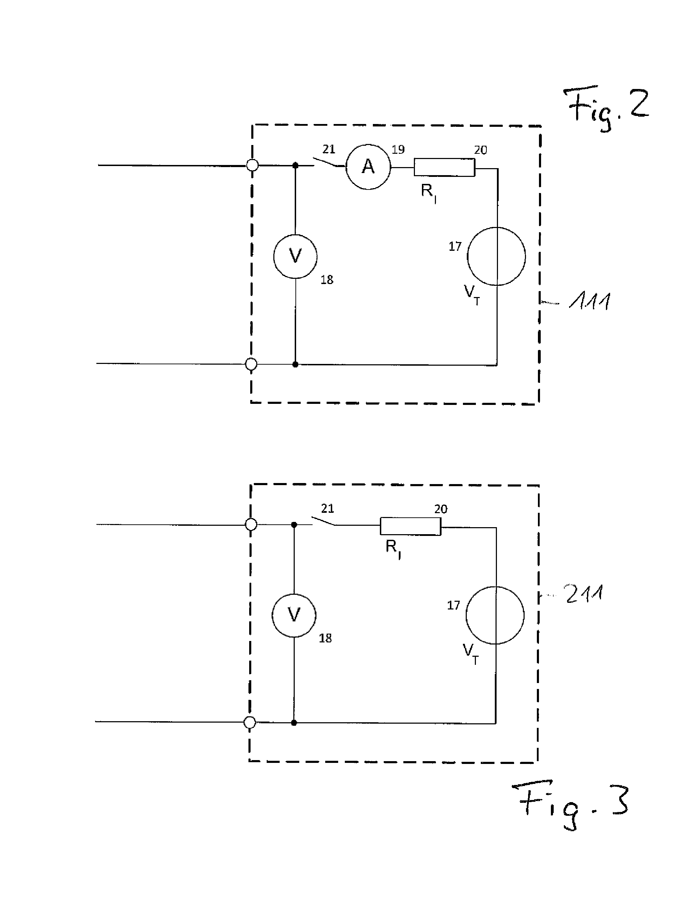

Bevor anhand von Fig. 2 und Fig. 3 auf Ausführungsbeispiele einer Prüfeinrichtung eingegangen wird, werden noch Varianten der Gesamtanordnung und Betriebsweisen der Gesamtanordnung in Fig. 1 und anderer Gesamtanordnungen erläutert.

Wird beim Fahrzeug das Schirmpotential der elektrischen Energieversorgungsleitung an nur einer Stelle über die primärseitige Wicklung eines Transformators mit dem Bezugspotenzial verbunden, wobei am Transformator sekundärseitig an unterschiedlichen Wicklungen eine Dämpfungseinrichtung und eine Prüfeinrichtung angeschlossen sind, wird die korrekte Funktion der Dämpfungseinrichtung durch die Prüfeinrichtung geprüft. Diese Prüfeinrichtung kann als die lokale Prüfeinrichtung oder eigene Prüfeinrichtung der Dämpfungseinrichtung bezeichnet werden.

Sind in einem Fahrzeug mehrere Dämpfungseinrichtungen vorhanden, ist den Dämpfungseinrichtungen vorzugsweise jeweils eine eigene Prüfeinrichtung zugeordnet, d. h. vorzugsweise sind die Dämpfungseinrichtung und die zugeordnete Prüfeinrichtung über denselben Trenntransformator an die Abschirmung der Energieversorgungsleitung gekoppelt. In diesem Fall kann jede der Dämpfungseinrichtungen durch die lokale, eigene Prüfeinrichtung auf korrekte Funktion geprüft werden. Alternativ oder zusätzlich kann jede der Prüfeinrichtungen auch das Dämpfungsverhalten des gesamten Systems und damit auch der nicht eigenen, entfernten Dämpfungseinrichtungen prüfen. Z. B. erzeugt jede der Prüfeinrichtungen ein Testsignal und wird die Reaktion des elektrischen Systems auf das Testsignal von jeder der Prüfeinrichtungen oder zumindest von einer Mehrzahl der Prüfeinrichtungen gleichzeitig gemessen. Dabei werden die Testsignale der verschiedenen Prüfeinrichtungen vorzugsweise zeitlich nacheinander in das elektrische System eingekoppelt. Durch jedes der Testsignale wird das elektrische System (das zumindest aus dem Trenntransformator zwischen Abschirmung und Bezugspotential oder Bezugspotentialen, der Energieversorgungsleitung, den Dämpfungseinrichtungen, optionalen weiteren Bauteilen der elektrischen Energieversorgung des Fahrzeugs und insbesondere auch aus zumindest Teilen der Fahrzeug-externen Energieversorgung bestehen kann) zu Schwingungen angeregt. Je nach den in dem Testsignal enthaltenen Frequenzen oder der Frequenz wird also das Schwingungsverhalten des Systems bei einer Frequenz oder mehreren Frequenzen oder in Frequenzbereichen geprüft.

In dem Fall, dass eine Mehrzahl der Prüfeinrichtungen jeweils eine Messeinrichtung aufweist, die zumindest eine Messgröße misst und somit die Prüfung des Dämpfungsverhaltens erlaubt, kann der Betrieb der einzelnen Prüfeinrichtungen in einen aktiven und in einen passiven Betrieb untergliedert werden. Im aktiven Betrieb wird sowohl ein Testsignal von der Prüfeinrichtung erzeugt als auch die Reaktion des Systems von der Messeinrichtung der Prüfeinrichtung gemessen. Im passiven Fall wird lediglich von der Messeinrichtung die Reaktion des Systems gemessen. Modifikationen sind möglich. Insbesondere kann im aktiven Betriebszustand lediglich ein Testsignal erzeugt und in das System eingekoppelt werden und nicht die Reaktion von der eigenen Messeinrichtung gemessen werden.

Vorzugsweise wird von allen an das System angeschlossenen Testsignalquellen nacheinander zumindest ein Testsignal erzeugt und wird die Reaktion des Systems vorzugsweise bei allen Testsignalen von allen Messeinrichtungen gemessen.

Vorzugsweise wird der Betrieb aller Dämpfungseinrichtungen und aller Prüfeinrichtungen durch eine zentrale Leittechnik gesteuert. In Fig. 1 sind in jedem Fahrzeugteil 51 a, 51 b Teile der Leittechnik durch einen mit dem Bezugszeichen 71 bezeichneten Kasten angedeutet. Die Steuerwirkung der Leittechnik ist durch Pfeile angedeutet. Auf diese Weise können insbesondere die zuvor genannten Verfahrensweisen von der Leittechnik gesteuert werden.

Die in Fig. 2 dargestellte Prüfeinrichtung weist links in der Fig. 2 elektrische Anschlüsse auf, die an der gestrichelten Umrisslinie 111 in jeweils einem Kreis enden. Diese Kreise sind z. B. die in Fig. 1 dargestellten Kreise, die die Anschlüsse der Prüfeinrichtung 11 zu der Sekundärwicklung des Trenntransformators 62 darstellen.

Die in Fig. 2 dargestellte Prüfeinrichtung 111 weist eine Spannungs-Messeinrichtung 18 auf, die zwischen die genannten Anschlüsse geschaltet ist. Ferner ist parallel zu der Spannungs-Messeinrichtung 18 eine Reihenschaltung eines Schalters 21, einer Strom-Messeinrichtung 19, eines ohmschen Widerstandes 20 und einer Signalquelle 17 geschaltet. Bei dem Widerstand 20 handelt es sich um den in Form eines Ersatzschaltbildes dargestellten Innenwiderstand der Signalquelle 17. Z. B. wird der Schalter, der auch entfallen kann, zum Umschalten zwischen dem oben genannten aktiven und oben genannten passiven Betriebsmodus genutzt. Im aktiven Betriebsmodus ist der Schalter 21 geschlossen. Im passiven Betriebsmodus ist der Schalter geöffnet. Alternativ zu einem Schalter 21 wie in Fig. 2 und Fig. 3 dargestellt, kann zwischen dem aktiven und dem passiven Betriebsmodus auch auf andere Weise umgeschaltet werden. Insbesondere kann die Signalquelle 17 ein- und ausgeschaltet werden, d. h. z. B. erzeugt die Signalquelle 17 im passiven Betriebsmodus kein Signal und weist vorzugsweise einen nahezu unendlich hohen Innenwiderstand auf.

Beim Betrieb der Prüfeinrichtung 111 wird z. B. bei geöffnetem Schalter 21 lediglich die zwischen den Anschlüssen abfallende Spannung durch die Spannungs-Messeinrichtung 18 gemessen. Aufgrund der Verbindung zur Schnittstelle zwischen der Abschirmung und dem Bezugspotential können damit wesentliche Informationen über das Schwingungsverhalten des elektrischen Systems gewonnen werden.

Bei geschlossenem Schalter 21 wird zusätzlich der Strom gemessen, der von der Signalquelle 17 erzeugt wird.

Bei der modifizierten Prüfungseinrichtung 211 gemäß Fig. 3 ist gegenüber der Prüfeinrichtung 111 gemäß Fig. 2 die Strom-Messeinrichtung 19 weggelassen. Dies verdeutlicht, dass die Strommessung im aktiven Betrieb der Prüfeinrichtung nicht zwingend für die Auswertung des Dämpfungsverhaltens erforderlich ist. Bereits aus der Information der Spannungs-Messeinrichtung 18 kann unter Berücksichtigung des Innenwiderstandes 20 ermittelt werden, ob z. B. bei Anregung des Systems durch die Spannungsquelle 17 Spannungsamplituden einer bestimmten Frequenz, mehrerer bestimmter Frequenzen und/oder in einem Frequenzbereich unzulässig hoch sind.

Zur Messung des Verhaltens bei einer bestimmten Frequenz wird z. B. ein sinusförmiges Testsignal dieser Frequenz von der Signalquelle 17 oder von einer entsprechenden Signalquelle einer anderen Prüfeinrichtung erzeugt und in das zu überwachende System eingekoppelt.

Um das Schwingungsverhalten bei mehreren Frequenzen gleichzeitig zu überprüfen, wird vorzugsweise ein impulsförmiges Testsignal von der Signalquelle 17 oder einer anderen Signalquelle in das System eingekoppelt, so dass die Reaktion des Systems für die in dem Testsignal enthaltenen Frequenzen geprüft wird. Alternativ können die einzelnen Frequenzbereiche auch nacheinander geprüft werden. Die Frequenz des sinusförmigen Testsignals wird hierbei auf die jeweils zu prüfende Frequenz geändert.

Generell wird vorzugsweise automatisch und bevorzugter Maßen wiederholt eine Prüfung auf ausreichende Dämpfung durchgeführt, insbesondere in einer der oben beschriebenen Verfahrensweisen. Wird bei der Auswertung festgestellt, dass kein ausreichendes Dämpfungsverhalten vorhanden ist, wird vorzugsweise automatisch ein Fehlersignal erzeugt, das z. B. zu einer Anzeige für das Betriebspersonal des Fahrzeugs führt und/oder in einem Diagnosesystem abgespeichert wird.
Aus Gründen der Betriebssicherheit kann im Fall einer unzureichenden Dämpfung auch sofort ein automatischer Eingriff in die Fahrzeugsteuerung erfolgen, z.B. die Auslösung einer Traktionssperre oder / und des Hauptschalters 16.

Insbesondere wird die Impedanz des überwachten elektrischen Systems, die durch Strom- und Spannungsmessung bestimmt wird, ausgewertet. Vorzugsweise wird die Impedanz bei mehreren Frequenzen innerhalb eines zu überwachenden Frequenzbereichs (z. B. des oben genannten Tonfrequenzbereichs oder eines anderen Tonfrequenzbereichs) bestimmt. Insbesondere die Impedanz oder der Impedanzverlauf über die verschiedenen Frequenzen oder innerhalb des Frequenzbereichs kann mit einem Sollwert oder Sollverlauf verglichen werden. Liegen der durch Messung bestimmte Impedanzwert oder die bestimmten Impedanzwerte innerhalb eines vorgegebenen Toleranzbereichs um den Sollwert oder die Sollwerte oder um den Sollverlauf, wird eine ausreichende Dämpfungswirkung festgestellt. Anderenfalls kann z. B. das oben genannte Fehlersignal erzeugt und ausgegeben werden.

Varianten der oben beschriebenen Verfahrensweisen sind möglich. Insbesondere kann statt eines einzelnen Testimpulses eine Impulsfolge von einer Signalquelle in das System eingekoppelt werden.

Für die Auswertung der Reaktion des Systems, wenn wie im Beispiel der Fig. 3 die Prüfeinrichtung keine Strom-Messeinrichtung aufweist, wird insbesondere der Innenwiderstand der Signalquelle berücksichtigt, der z. B. vorher gemessen oder auf andere Weise bestimmt werden kann.

Fig. 4 zeigt ein Ausführungsbeispiel einer Dämpfungseinrichtung 110, die z. B. als Dämpfungseinrichtung 10 in der Anordnung gemäß Fig. 1 verwendet werden kann. An die oben in Fig. 4 durch Kreise dargestellten Anschlüsse, über die die Dämpfungseinrichtung an die Tertiärwicklung 63 in Fig. 1 oder an die sekundäre oder tertiäre Wicklung eines Transformators einer anderen Ausgestaltung angeschlossen werden kann, ist eine Parallelschaltung von mehreren Blöcken 81 von passiven elektrischen Bauteilen geschaltet. In dem Ausführungsbeispiel der Fig. 4 sind vier Blöcke 81 a, 81 b, 81 c, 81 d parallel geschaltet. Die Anzahl der Blöcke 81 kann jedoch variieren. Jeder der Blöcke 81 ist über einen Schalter 22 mit zumindest einem benachbarten parallel geschalteten Block 81 verbunden. Bei geöffnetem Schalter sind alle Blöcke, die weiter von den Anschlüssen entfernt angeordnet sind, abgeschaltet und tragen nicht zu den Dämpfungseigenschaften der Dämpfungseinrichtung bei.
Alternativ können die Blöcke aus Fig. 4 auch in Reihe geschaltet werden. Die Schalter liegen in diesem Fall parallel zu den Blöcken und schließen diese im eingeschalteten Zustand kurz.

Auf diese Weise kann das Dämpfungsverhalten der Dämpfungseinrichtung angepasst werden, insbesondere an den Betrieb des Fahrzeugs an einem andersartigen Energieversorgungsnetz. Die Fahrzeug-externen Energieversorgungsnetze können sehr unterschiedliche Resonanz-Eigenschaften haben bzw. in sehr unterschiedlicher Weise mit der Fahrzeug-internen Energieversorgungsanordnung zusammenwirken. Eine Veränderung der Dämpfungseigenschaften der Dämpfungseinrichtung ist jedoch auch z. B. bei einem Ausfall zumindest eines Teils der Fahrzeug-internen Energieversorgungsanordnung sinnvoll, z. B. bei einem Defekt eines Antriebsstranges zur Erzeugung von Traktionsenergie für das Fahrzeug oder beim Defekt eines Transformators, z. B. eines Haupttransformators, wie in Fig. 1 dargestellten Haupttransformatoren 7. Z. B. beim Ausfall eines Antriebsstranges oder einem Ausfall eines anderen Teilsystems kann auch ein Teil der Energieversorgungsleitung durch Öffnen eines Schalters spannungsfrei geschaltet werden, wodurch sich insbesondere die Kapazitäten innerhalb des Fahrzeugs ändern. Daraus resultiert ein anderer frequenzabhängiger Verlauf der Fahrzeugimpedanz. Durch Zuschalten oder Abschalten bzw. Kurzschließen von Blöcken passiver Bauelemente der Dämpfungseinrichtung oder Dämpfungseinrichtungen kann das Dämpfungsverhalten angepasst und optimiert werden.

In dem Ausführungsbeispiel der Fig. 4 besteht jeder Block 81 aus einer Induktivität und einem parallel dazu geschalteten ohmschen Widerstand. Die Schaltungsanordnung kann jedoch auch als Ersatzschaltbild aufgefasst werden, d. h. der Widerstand kann Bestandteil der induktiven Bauteils (Drossel) sein oder die Induktivität ist Bestandteil des Widerstandes.

Insbesondere wird der zumindest eine Schalter der Dämpfungseinrichtung, mit dem zumindest ein Block zu- oder abgeschaltet bzw. kurzgeschlossen werden kann, von einer zentralen Steuerung, insbesondere der oben genannten Leittechnik des Fahrzeugs gesteuert. Die Leittechnik ist somit in der Lage, nicht nur den Betrieb der Prüfeinrichtung, sondern auch die Dämpfungseigenschaften der Dämpfungseinrichtung zu steuern, wie dies bereits durch zwei Pfeile in jedem Fahrzeugteil 51 a, 51 b in Fig. 1 angedeutet ist, die von den Blöcken 71 ausgehen. In jedem Fall ermöglicht es die automatische Steuerung der Dämpfungseigenschaften der Dämpfungseinrichtung, auf veränderte Betriebssituationen zu reagieren und die Dämpfung zu optimieren.

## Patentansprüche

1. Anordnung zur Versorgung eines Schienenfahrzeugs (51) mit elektrischer Energie, wobei:
• die Anordnung eine Energieversorgungsleitung (3) mit einem Anschluss zum Anschließen der Energieversorgungsleitung (3) an ein Fahrzeug-externes Stromnetz (1) aufweist, wobei die Energieversorgungsleitung (3) eine Abschirmung (55a, 55b) aufweist,
• die Abschirmung (55) über eine elektrische Verbindung (58) mit einem von dem elektrischen Potenzial der Abschirmung (55) unterschiedlichen Bezugspotenzial, insbesondere Massepotenzial (UM), verbunden ist,
• die Anordnung eine Dämpfungseinrichtung (10) aufweist, die ausgestaltet ist, elektrische Schwingungen der Anordnung unter Beteiligung der Energieversorgungsleitung (3) zu dämpfen,
**dadurch gekennzeichnet, dass**
• die Dämpfungseinrichtung (10) induktiv mit der elektrischen Verbindung (58) zwischen der Abschirmung (55) und dem Bezugspotenzial gekoppelt ist.

2. Anordnung zur Versorgung eines Schienenfahrzeugs (51) mit elektrischer Energie, wobei:
• die Anordnung eine Energieversorgungsleitung (3) mit einem Anschluss zum Anschließen der Energieversorgungsleitung (3) an ein Fahrzeug-externes Stromnetz (1) aufweist, wobei die Energieversorgungsleitung (3) eine Abschirmung (55a, 55b) aufweist,
• die Abschirmung (55) über eine elektrische Verbindung (58) mit einem von dem elektrischen Potenzial der Abschirmung (55) unterschiedlichen Bezugspotenzial, insbesondere Massepotenzial (UM), verbunden ist,
• die Anordnung eine Dämpfungseinrichtung (10) aufweist, die ausgestaltet ist, elektrische Schwingungen der Anordnung unter Beteiligung der Energieversorgungsleitung (3) zu dämpfen,
**dadurch gekennzeichnet, dass**
eine Prüfeinrichtung (11), die ausgestaltet ist, eine korrekte Funktion der Dämpfungseinrichtung (10) zu prüfen, induktiv mit der elektrischen Verbindung (58) zwischen der Abschirmung (55) und dem Bezugspotenzial gekoppelt ist.

3. Anordnung nach Anspruch 2, wobei die Prüfeinrichtung (11) eine Messeinrichtung (18, 19) aufweist, die ausgestaltet ist, eine Messgröße zu messen, die ein Maß für eine korrekte Funktion der Dämpfungseinrichtung (10) ist.

4. Anordnung nach Anspruch 2 oder 3, wobei die Prüfeinrichtung (11) eine Signalerzeugungseinrichtung (17) aufweist, die ausgestaltet ist, ein Signal zu erzeugen, mit dem die Anordnung oder ein Teil der Anordnung zu elektrischen Schwingungen anregbar ist.

5. Anordnung nach einem der Ansprüche 1 bis 4 oder nach Anspruch 1 und einem der Ansprüche 2 bis 4, wobei ein Trenntransformator die induktive Kopplung der Dämpfungseinrichtung (10) und/oder der Prüfeinrichtung (11) einerseits und der elektrischen Verbindung (58) andererseits bewirkt.

6. Anordnung nach Anspruch 1 und einem der Ansprüche 2 bis 4, wobei die Dämpfungseinrichtung (10) und die Prüfeinrichtung (11) induktiv mit der elektrischen Verbindung (58) zwischen der Abschirmung (55) und dem Bezugspotenzial gekoppelt sind.

7. Anordnung nach Anspruch 1 und einem der Ansprüche 2 bis 4, wobei die Dämpfungseinrichtung (10) induktiv mit einer ersten elektrischen Verbindung (58a) zwischen der Abschirmung (55a) und dem Bezugspotenzial gekoppelt ist und die Prüfeinrichtung (11) induktiv mit einer zweiten elektrischen Verbindung (58b) zwischen der Abschirmung (55b) und dem Bezugspotenzial gekoppelt ist.

8. Anordnung nach Anspruch 1 und einem der Ansprüche 2 bis 4, oder nach Anspruch 7, wobei die Abschirmung (55) zwei elektrisch nicht unmittelbar miteinander verbundene Abschirmungssegmente (55a, 55b) aufweist, die jeweils über eine elektrische Verbindung (58a, 58b) mit einem Bezugspotenzial verbunden sind, wobei jede der elektrischen Verbindungen (58a, 58b) induktiv mit einer Dämpfungseinrichtung (10) und/oder einer mit einer Prüfeinrichtung (11) gekoppelt ist.

9. Verfahren zur Versorgung eines Schienenfahrzeugs (51) mit elektrischer Energie, wobei:
• das Schienenfahrzeug (51) über eine Energieversorgungsleitung (3), die mit einem Fahrzeug-externen Stromnetz (1) verbunden ist, mit elektrischer Energie versorgt wird, wobei die Energieversorgungsleitung (3) mit einer Abschirmung (55) betrieben wird,
• die Abschirmung (55) während der Versorgung des Schienenfahrzeugs (51) mit elektrischer Energie über die Energieversorgungsleitung (3) über eine elektrische Verbindung (58) mit einem von dem elektrischen Potenzial der Abschirmung (55) unterschiedlichen Bezugspotenzial, insbesondere Massepotenzial (UM), verbunden ist,
• elektrische Schwingungen der Anordnung unter Beteiligung der Energieversorgungsleitung (3) gedämpft werden,
**dadurch gekennzeichnet, dass**
• die Dämpfungseinrichtung (10) induktiv gekoppelt mit der elektrischen Verbindung (58) zwischen der Abschirmung (55) und dem Bezugspotenzial betrieben wird.

10. Verfahren zur Versorgung eines Schienenfahrzeugs (51) mit elektrischer Energie, wobei:
• das Schienenfahrzeug (51) über eine Energieversorgungsleitung (3), die mit einem Fahrzeug-externen Stromnetz (1) verbunden ist, mit elektrischer Energie versorgt wird, wobei die Energieversorgungsleitung (3) mit einer Abschirmung (55) betrieben wird,
• die Abschirmung (55) während der Versorgung des Schienenfahrzeugs (51) mit elektrischer Energie über die Energieversorgungsleitung (3) über eine elektrische Verbindung (58) mit einem von dem elektrischen Potenzial der Abschirmung (55) unterschiedlichen Bezugspotenzial, insbesondere Massepotenzial (UM), verbunden ist,
• elektrische Schwingungen der Anordnung unter Beteiligung der Energieversorgungsleitung (3) gedämpft werden,
**dadurch gekennzeichnet, dass**
eine Prüfeinrichtung (11), die induktiv mit der elektrischen Verbindung (58) zwischen der Abschirmung (55) und dem Bezugspotenzial gekoppelt ist, prüft, ob die elektrischen Schwingungen ausreichend gedämpft werden.

11. Verfahren nach Anspruch 10, wobei die Prüfeinrichtung (11) eine Messgröße misst, die ein Maß für eine korrekte Funktion der Dämpfungseinrichtung (10) ist, und durch Auswertung der Messgröße ermittelt, ob elektrische Schwingungen ausreichend gedämpft werden.

12. Verfahren nach Anspruch 10 oder 11, wobei die Prüfeinrichtung (11) ein Signal erzeugt, mit dem die Anordnung oder ein Teil der Anordnung zu elektrischen Schwingungen angeregt wird.

13. Verfahren nach Anspruch 9 und einem der Ansprüche 10 bis 12, wobei die Dämpfungseinrichtung (10) und die Prüfeinrichtung (11) induktiv mit der elektrischen Verbindung (58) zwischen der Abschirmung (55) und dem Bezugspotenzial gekoppelt betrieben werden.

14. Verfahren nach Anspruch 9 und einem der Ansprüche 10 bis 13, wobei die Dämpfungseinrichtung (10), oder eine von mehreren Dämpfungseinrichtungen, induktiv mit einer ersten elektrischen Verbindung (58a) zwischen der Abschirmung (55) und dem Bezugspotenzial gekoppelt betrieben wird und die Prüfeinrichtung (11), oder eine von mehreren Prüfeinrichtungen, induktiv mit einer zweiten elektrischen Verbindung (58b) zwischen der Abschirmung (55) und dem Bezugspotenzial gekoppelt betrieben wird.

15. Verfahren nach Anspruch 9 und einem der Ansprüche 10 bis 13, oder nach Anspruch 15, wobei eine Dämpfungseinrichtung (10) und/oder eine Prüfeinrichtung (11) induktiv gekoppelt mit einer ersten elektrischen Verbindung (58a) zwischen einem ersten Abschirmungssegment (55a) der Abschirmung (55) und einem Bezugspotenzial betrieben wird, wobei eine Dämpfungseinrichtung (10) und/oder eine Prüfeinrichtung (11) induktiv gekoppelt mit einer zweiten elektrischen Verbindung (58b) zwischen einem zweiten Abschirmungssegment (55b) der Abschirmung (55) und einem Bezugspotenzial betrieben wird und wobei die Abschirmungssegmente (55a, 55b) zwei elektrisch nicht unmittelbar miteinander verbundene Abschirmungssegmente (55a, 55b) sind.
